# FASCICULE DE BREVET EUROPEEN

(11) **EP 3 420 125 B1**
(45) Date de publication et mention de la délivrance du brevet: **11.09.2024**
(21) Numéro de dépôt: 17706453.2
(22) Date de dépôt: 21.02.2017
(51) Int. Cl.: C30B 25/18, C30B 29/40

(54) **PROCÉDÉ PERMETTANT D'OBTENIR SUR UN SUBSTRAT CRISTALLIN UNE COUCHE SEMI-POLAIRE DE NITRURE**
VERFAHREN ZUR HERSTELLUNG EINER HALBPOLAREN NITRIDSCHICHT AUF EINEM KRISTALLINEN SUBSTRAT
METHOD MAKING IT POSSIBLE TO OBTAIN A SEMI-POLAR NITRIDE LAYER ON A CRYSTALLINE SUBSTRATE

(30) Priorité: 22.02.2016 FR 1651433
(43) Date de publication de la demande: 02.01.2019
(73) Titulaire: Commissariat à l'Énergie Atomique et aux Énergies Alternatives, 75015 Paris (FR); Centre National de la Recherche Scientifique, 75016 Paris (FR)
(72) Inventeur: FEUILLET, Guy, 38410 Saint-Martin d'Uriage (FR); EL KHOURY MAROUN, Michel, 06600 Antibes (FR); VENNEGUES, Philippe, 06600 Antibes (FR); ZUNIGA PEREZ, Jesus, 06410 Biot (FR)
(74) Mandataire: IPAZ
(86) Numéro de dépôt international: PCT/EP2017/053830
(87) Numéro de publication internationale: WO 2017/144429

(56) Documents cités:
- WO-A1-2015/160903
- WO-A1-2016/202899
- US-A1- 2012 276 722
- TASUKU MURASE ET AL: "Drastic Reduction of Dislocation Density in Semipolar (1122) GaN Stripe Crystal on Si Substrate by Dual Selective Metal-Organic Vapor Phase Epitaxy", JAPANESE JOURNAL OF APPLIED PHYSICS JPN. J. APPL. PHYS, 1 January 2011 (2011-01-01), pages 01AD04 - 1, XP055758288, Retrieved from the Internet <URL:https://iopscience.iop.org/article/10.1143/JJAP.50.01AD04/meta> [retrieved on 20201209], DOI: 10.1143/JJAP.50.01AD04
- M. KHOURY ET AL: "Growth of semipolar (2021) GaN layers on patterned silicon (114) 1° off by Metal Organic Vapor Phase Epitaxy", JOURNAL OF CRYSTAL GROWTH., vol. 419, 5 March 2015 (2015-03-05), NL, pages 88 - 93, XP055313417, ISSN: 0022-0248, DOI: 10.1016/j.jcrysgro.2015.02.098
- ANSAH ANTWI K K ET AL: "Crystallographically tilted and partially strain relaxed GaN grown on inclined {111} facets etched on Si(100) substrate", JOURNAL OF APPLIED PHYSICS, AMERICAN INSTITUTE OF PHYSICS, US, vol. 114, no. 24, 28 December 2013 (2013-12-28), XP012184193, ISSN: 0021-8979, [retrieved on 19010101], DOI: 10.1063/1.4856275

## Description

### DOMAINE TECHNIQUE DE L'INVENTION

La présente invention concerne en général les techniques de croissance de couches semi-polaires de nitrure (N) obtenues à partir d'un matériau pris parmi le gallium (Ga), l'indium (In) et l'aluminium (AI) sur une surface supérieure d'une couche cristalline.

L'invention trouve pour application avantageuse le domaine des diodes électroluminescentes (DEL).

### ÉTAT DE LA TECHNIQUE

Tous les dispositifs optoélectroniques commerciaux modernes et en particulier les diodes électroluminescentes (DEL) à forte intensité lumineuse qui ont déjà commencé à remplacer les ampoules d'éclairage à incandescence en raison de leur bien plus faible consommation électrique, utilisent des matériaux semi-conducteurs faits d'alliages à base de nitrure de gallium (GaN) et d'autres matériaux comme l'indium (In) et l'aluminium (AI). Ces matériaux sont obtenus dans des structures en couches où, typiquement, on doit réaliser une croissance hétéro-épitaxiale de la couche active du matériau à base de GaN à partir d'un substrat fait d'un matériau différent.

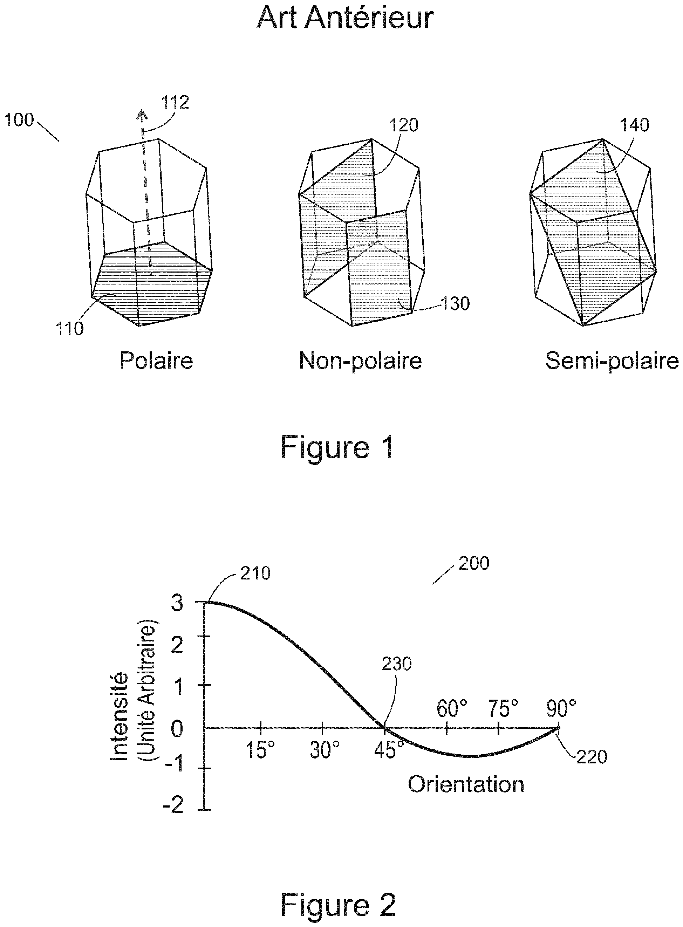

Comme représentée sur la **figure 1****,** la forme cristallographique stable d'alliages à base de GaN est la structure cristalline dite « wurtzite ». Dans cette structure hexagonale 100, il est commode de définir des plans cristallins tels que le plan « c » 110; le plan « a » 120 et le plan « m » 130. Comme il s'est avéré expérimentalement plus aisé de faire croître les matériaux à base de GaN selon la direction de l'axe « c » 112, perpendiculaire au plan du même nom, direction aussi qualifiée de polaire, la plupart des dispositifs produits le sont selon cette direction. Cependant, une conséquence négative de cette direction de croissance est qu'il permet à l'effet dit QCSE, acronyme de l'anglais « quantum confined Stark effect » c'est-à-dire « effet de confinement quantique de Stark », de se développer.

Cet effet, qui est induit par les forts champs électriques de polarisation internes qui se développent dans les couches GaN dont la croissance a été effectuée selon l'axe c ou polaire, se traduit notamment par une baisse significative de l'efficacité de recombinaison des paires électron-trou dans les puits quantiques de la diode et donc par une forte perte d'efficacité lumineuse de ces DELs.

Pour surmonter les problèmes liés à la présence de ces forts champs électriques, il a été envisagé de faire croitre le GaN selon des plans cristallographiques différents de l'axe polaire. Comme illustré en figure 1, les plans a et m, 120 et 130, sont des plans dans des directions non-polaires. On peut aussi envisager une croissance dans un plan intermédiaire, par exemple 140, dans une direction dite semi-polaire.

La **figure 2** illustre comment varie la discontinuité de polarisation totale aux interfaces dans une hétérostructure à puits quantique GaN / InGaN en fonction de l'angle d'inclinaison par rapport à l'axe c. On note que cette discontinuité de polarisation est en effet maximale 210 pour l'orientation polaire (0°) et nulle 220 pour l'orientation non-polaire (90°). Elle passe aussi par zéro 230 pour une orientation semi-polaire (autour de 45°).

Différentes techniques ont bien été proposées pour obtenir une croissance, notamment semi-polaire, de couches à base de GaN réduisant ainsi fortement les effets de polarisation. Celles-ci ont permis d'obtenir une amélioration significative des performances des DELs ainsi produites, mais par épitaxie sur des substrats GaN. Ces substrats étant encore de taille limitée et de coût prohibitif, ces techniques se sont avérées être peu susceptibles d'industrialisation. Par ailleurs, ces techniques doivent permettre de produire des couches ou templates sinon exemptes de tout défaut cristallographique au moins présentant des taux de défauts suffisamment faibles afin d'obtenir des rendements de fabrication élevés et donc de faibles coûts de production.

Un procédé de croissance d'un film de GaN semi-polaire avec une plus faible densité des défauts est connu par le document US 2012/0276722 A1. Murase et coll. ont publié un article de recherche sur la réduction drastique de la densité de dislocation dans le cristal à rayures GaN semi-polaire (1122) sur substrat Si par épitaxie double méta-organique sélective en phase vapeur, dans Japanese Journal of Applied Physics, 50, 2011, 01 AD04, DOI: 10.1143/JJAP.50.01AD04.

Ainsi un objet de la présente consiste à proposer une solution pour résoudre certaines au moins de ces contraintes.

Plus précisément, un objet de l'invention consiste à proposer une solution susceptible de pouvoir produire à bas coût dans un environnement industriel des substrats notamment d'orientation semi-polaire de grande taille présentant un niveau de défauts cristallographiques faible. Ces substrats, également désignés pseudo-substrats, peuvent par exemple servir de base pour la formation par épitaxie d'autres structures telles que des LEDs par exemple.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un mode de réalisation, la présente invention telle que définie dans la revendication 1 porte sur un procédé permettant d'obtenir au moins une couche semi-polaire de nitrure obtenue à partir d'un matériau à base de gallium (Ga) et d'azote (N) sur une surface supérieure d'un substrat cristallin, le procédé comprenant au moins les étapes suivantes:
- graver une pluralité de rainures, de préférence parallèles à partir de la surface supérieure du substrat cristallin, chaque rainure comprenant au moins deux facettes inclinées opposées, au moins l'une desdites deux facettes opposées présentant une orientation cristalline {111} ;
- former un masque au-dessus de la surface supérieure du substrat cristallin de telle sorte que les facettes opposées auxdites facettes présentant une orientation cristalline {111} soient masquées et que lesdites facettes présentant une orientation cristalline {111} ne soient pas masquées ;
- former ladite couche semi-polaire de nitrure par croissance épitaxiale à partir desdites facettes non masquées présentant une orientation cristalline {111}.

Ladite étape de formation de ladite couche semi-polaire comprend au moins les étapes suivantes
- au moins une première phase de croissance épitaxiale, réalisée à partir desdites facettes non masquées présentant une orientation cristalline {111} de manière à former un germe dans une pluralité au moins de rainures parallèles;
- interruption de la première phase de croissance épitaxiale lorsque ledit germe présente une facette inclinée présentant une orientation cristalline (0001) et une facette supérieure présentant une orientation semi-polaire cristalline (1011);
- une étape de traitement de surface comprenant une modification d'une portion supérieure du germe par mise en présence du germe avec au moins un gaz comprenant du silicium (Si) de manière à former à la surface du germe une portion modifiée comprenant du silicium (Si);
- au moins une deuxième phase de croissance épitaxiale dudit matériau, réalisée à partir de ladite facette inclinée présentant une orientation cristalline (0001).

Il s'est avéré que la présence de la portion modifiée comprenant du silicium permet de stopper ou de dévier les défauts et dislocations qui se propagent depuis les facettes du substrat cristallin qui présentent une orientation cristalline {111} et plus précisément depuis l'interface Si {111]/ GaN ou Si {111]/AIN/GaN si une couche de AIN a été formé avant croissance du GaN.

Les dislocations issues des facettes du substrat présentant une orientation cristalline {111}, s'inclinent pendant la croissance du germe et débouchent sur la facette supérieure semi-polaire présentant une orientation cristalline (0001).

Les défauts et dislocations ne parviennent pas, ou que peu, jusqu'aux facettes inclinées du germe qui présentent une orientation cristalline (0001). Lors de la deuxième phase de croissance épitaxiale, la couche semi-polaire croît à partir de ces facettes inclinées présentant une orientation cristalline (0001) et recouvre le dessus de la portion modifiée comprenant du silicium qui surmonte la facette supérieure du germe. Ainsi, au-dessus de la portion modifiée comprenant du silicium, la couche semi-polaire présente peu ou pas de défauts et dislocations.

De préférence, la deuxième phase de croissance épitaxiale étant poursuivie jusqu'à coalescence de germes de rainures parallèles adjacentes.

L'invention permet ainsi d'améliorer significativement la qualité des composants obtenus.

De manière optionnelle, le procédé de l'invention peut en outre avoir au moins l'une quelconque parmi les caractéristiques et étapes facultatives prises séparément ou en combinaison :
Selon un mode de réalisation, au cours de la deuxième phase de croissance épitaxiale ladite couche semi-polaire de nitrure (GaN) recouvre une partie au moins de la portion modifiée comprenant du silicium.

Selon un mode de réalisation, la portion modifiée comprenant du silicium est continue sur ladite facette supérieure du germe. La portion modifiée comprenant du silicium permet de bloquer ou dévier les dislocations se propageant dans le germe depuis la facette du substrat présentant une orientation cristalline {111}.

Selon un mode de réalisation, la portion modifiée comprenant du silicium est absente ou discontinue sur la facette inclinée présentant une orientation cristalline (0001).

Selon un mode de réalisation, la portion modifiée comprenant du silicium présente sur ladite facette inclinée une épaisseur plus faible que sur la facette supérieure et suffisamment faible pour permettre une reprise de croissance par épitaxie dudit matériau à partir de ladite facette inclinée présentant une orientation cristalline (0001).

Le substrat cristallin est un matériau à base de silicium. Il est par exemple constitué de silicium.

Selon un mode de réalisation, la portion modifiée comprenant du silicium comprend du gallium (Ga), de l'azote (N) et du silicium (Si).

Selon un mode de réalisation, la portion modifiée comprenant du silicium qui est présente sur la facette supérieure a une épaisseur strictement supérieure à une couche monoatomique et de préférence supérieure ou égale à seize couches monoatomiques. Selon un mode de réalisation, la portion modifiée comprenant du silicium présente sur la facette supérieure a une épaisseur strictement supérieure à 0,3 nm, de préférence supérieure à 4 nm et de préférence supérieure à 5 nm.

Selon un mode de réalisation, la portion modifiée comprenant du silicium présente sur la facette inclinée a une épaisseur égale à une seule couche monoatomique. Selon un mode de réalisation, la portion modifiée comprenant du silicium présente sur la facette inclinée a une épaisseur égale ou inférieure à 0,3 nm

Selon un mode de réalisation, ladite modification d'une portion supérieure du germe comprend une exposition du germe à un flux combiné de gaz comprenant du SiH4 et du NH3.

Selon un mode de réalisation, ladite modification d'une portion supérieure du germe comprend une exposition du germe à un flux combiné de gaz comprenant du SiH4 et du NH3 et on contrôle l'épaisseur de la portion modifiée en régulant notamment le rapport de flux de SiH4 et NH3 et/ou en régulant la durée d'exposition c'est-à-dire la durée d'injection des gaz.

Selon un mode de réalisation, l'épaisseur de la portion modifiée comprenant du silicium est contrôlée en régulant au moins l'un des paramètres suivants : débit de l'au moins un gaz, température et pression d'injection de l'au moins un gaz comprenant du silicium.

Là où le germe est modifié pour former cette portion comprenant du Si, on ne voit pas apparaître une couche de cristallinité différente. Seule une variation de contraste chimique est observée à cette interface. La durée du traitement, la température, la pression du réacteur et les flux de gaz utilisés pour ce traitement sont les paramètres d'ajustement qui pilotent l'épaisseur de cette portion interfaciale formant une zone de blocage des dislocations.

Avantageusement et selon l'invention, cette formation « in situ » permet de former automatiquement une zone modifiée comprenant du silicium qui soit non-continue sur la facette inclinée et continue sur la facette supérieure. Ce dépôt « in situ » permet de former une couche très fine et soigneusement contrôlée.

Selon un mode de réalisation, au moins la première phase de croissance épitaxiale est effectuée dans un réacteur et l'étape de modification d'une portion supérieure du germe est effectuée dans le même réacteur.

Selon un mode de réalisation, la modification d'une portion supérieure du germe est effectuée par épitaxie en phase vapeur aux organométalliques (MOCVD - metalorganic chemical vapor déposition). Ainsi, le traitement de surface est réalisé in situ dans le même bâti d'épitaxie MOCVD, que celui utilisé pour la croissance du GaN.

Selon un mode de réalisation, ladite interruption est déclenchée au bout d'une durée prédéterminée en fonction des conditions utilisée parmi lesquelles figurent : le débit de gaz, la température, la pression.

Selon un mode de réalisation, la teneur en silicium de la portion modifiée située au-dessus de la facette supérieure présentant une orientation semi-polaire cristalline (101̅1) est comprise entre 3% et 20% et de préférence entre 3% et 10% en pourcentage atomique.

La facette supérieure présentant une orientation cristalline (0001) est semi-polaire.

Selon un mode de réalisation, le nitrure est du nitrure de gallium (GaN).

Par ailleurs, de manière également optionnelle, le procédé de l'invention peut en outre présenter au moins l'une quelconque parmi les caractéristiques et étapes facultatives prises séparément ou en combinaison :
Selon un mode de réalisation, le matériau est du GaN et avant l'étape de croissance épitaxiale dudit matériau à partir des facettes présentant une orientation cristalline {111}, on forme une couche tampon d'AIN sur les facettes présentant une orientation cristalline {111}.

Ainsi ladite étape de croissance épitaxiale comprend :
- une première croissance épitaxiale d'un matériau à base de nitrure d'aluminium (AIN) à partir desdites facettes non masquées qui présentent une orientation cristalline {111} ;
- puis au moins une seconde croissance épitaxiale d'un matériau à base de nitrure de gallium (GaN) à partir dudit matériau à base de nitrure d'aluminium (AIN).

Cela permet notamment d'éviter le contact entre GaN et le silicium du substrat et de réduire ainsi les risques de détérioration de type melt back etching (gravure de refusion).

Selon un mode de réalisation, ladite direction principale selon lesquelles les rainures s'étendent, correspond à une direction commune au plan de ladite surface supérieure du substrat cristallin et au plan (111) de ce même substrat.

Le substrat est choisi parmi les matériaux susceptibles de permettre la croissance d'une couche semi-polaire de nitrure obtenue à partir d'un matériau à base de gallium (Ga) et d'azote (N).

Le substrat est choisi parmi les matériaux susceptibles de révéler par gravure des facettes présentant une orientation cristalline <111>. Selon un mode de réalisation, le substrat cristallin est de symétrie cubique.

Selon un mode de réalisation, le substrat cristallin est à base de l'un des matériaux suivants, éventuellement dopé, ou est formé de l'un des matériaux suivants ou d'un alliage des matériaux suivants : Si, Ge, GaAs.

Un substrat « à base » d'un matériau donné signifie que le substrat peut être formé de ce matériau uniquement ou de ce matériau dopé avec un autre matériau.

Selon un mode de réalisation, le substrat est à base de ou est en silicium cristallin ou monocristallin. Dans ce cas, il peut s'agir d'un substrat massif de silicium ou d'un substrat élaboré de type silicium sur isolant (SOI). Dans ces deux cas, la surface supérieure du substrat cristallin est en silicium cristallin.

Selon un mode de réalisation non limitatif, le rapport molaire V/III dudit matériau comprenant du nitrure (N) et au moins l'un parmi le gallium (Ga), entre 50 et 7000.

Selon un mode de réalisation non limitatif, ledit rapport molaire V/III dudit matériau comprenant du nitrure (GaN) et le gallium (Ga) est compris entre 400 et 800 et de préférence entre 550 et 750.

Selon un mode de réalisation, l'étape de formation d'un masque comprend un dépôt directif d'un matériau de masquage, exécuté de telle sorte que tout le substrat cristallin soit recouvert à l'exception desdites facettes qui présentent une orientation cristalline {111}.

Selon un mode de réalisation, le matériau de masquage comprend au moins l'un parmi les matériaux suivants: l'oxyde de silicium (SiO2), le nitrure de silicium (SiN), le nitrure de titane (TiN).

Selon un mode de réalisation, la pluralité de rainures parallèles présente un pas p1 qui est compris entre 50 nm et 20 µm.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre la structure cristallographique hexagonale d'alliages à base de GaN et les plans de croissance polaire, non polaire et semi-polaire.
La FIGURE 2 montre la discontinuité de la polarisation totale qui se développe en fonction de l'orientation de la croissance épitaxiale.
La FIGURE 3, composée des figures 3a à 3d, illustre un type de technique qui a été développée pour s'affranchir des problèmes liés à une croissance cristalline d'un matériau à base de GaN selon un axe polaire.
La FIGURE 4, composée des figures 4a à 4g, illustre un exemple de procédé selon l'invention.
La FIGURE 5 montre des résultats expérimentaux obtenus avec le procédé de l'invention.

Les figures sont données à titre d'exemples et ne sont pas limitatives de l'invention. Elles sont des représentations schématiques de principe, destinées à faciliter la compréhension de l'invention et ne sont donc pas nécessairement à la même échelle que les applications pratiques. En particulier, les épaisseurs relatives des différentes couches et des germes ne sont pas représentatives de la réalité.

### DESCRIPTION DÉTAILLÉE DE L'INVENTION

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact, soit en étant séparée d'elle par au moins une autre couche ou au moins un autre élément.

Dans la description qui suit, l'épaisseur ou la hauteur est prise selon une direction perpendiculaire aux faces principales des différentes couches. Sur les figures, l'épaisseur ou la hauteur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures

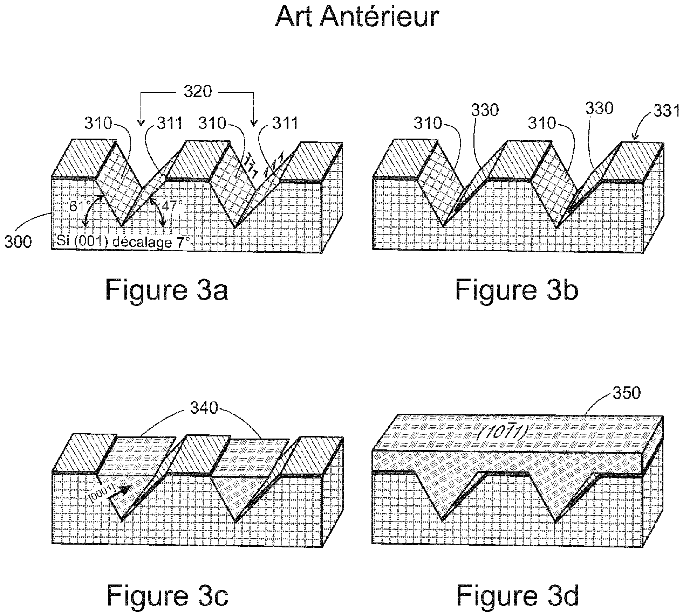

La **figure 3****,** composée des figures 3a à 3d, illustre un type de techniques pour s'affranchir des problèmes mentionnés précédemment et liés à une croissance cristalline d'un matériau à base de GaN selon un axe polaire. La figure 3 concerne essentiellement des techniques dans lesquelles on parvient à faire croître une couche à base de GaN d'orientation semi-polaire en partant de facettes inclinées 310 de rainures 320 en V créées à la surface du substrat de départ 300. La croissance se fait selon une méthode qui a été initialement proposée par un groupe de chercheurs japonais et publiée en langue anglaise en 2002 dans le « Journal of crystal growth », vol. 242(1), pages 82-86, sous le titre « Growth of (1101) GaN on a 7-degree off-oriented (001) Si substrate by sélective MOVPE » par Yoshio Honda et ses coauteurs.

Comme illustré dans la figure 3 l'idée de base développée dans la publication ci-dessus est de permettre que la croissance épitaxiale se fasse essentiellement à partir d'une seule des facettes 310, 311 de chaque rainure 320 créée préalablement par gravure à la surface d'un substrat 300 qui a été par ailleurs choisi dans ce cas avec une orientation cristalline décalée de sept degrés d'angle par rapport au plan (001) tel que défini par son indice standard d'orientation cristallographique dit de Miller.

Comme indiqué, les facettes 310, 311 opposées de chaque rainure 320 du substrat de silicium présentent alors une orientation cristallographique qui est respectivement de (1̅1̅1) et de (111). Les rainures 320 s'étendent dans leur plus grande longueur selon une direction principale contenue dans un plan parallèle au plan dans lequel le substrat s'étend principalement. Cette direction principale est commune au plan de la surface supérieure du substrat 300 et au plan (111).

Pour un substrat 300 en silicium, la révélation des facettes 310 d'orientation <111> se fait par attaque chimique à l'aide de KOH ou hydroxyde de potassium. Le substrat 300 de départ est masqué et l'attaque chimique a lieu dans les ouvertures du masque 331, formant ainsi des rainures 320. Le temps d'attaque fixe la profondeur de gravure et donc la hauteur des facettes <111 > 310 exposées. Puisque la croissance de GaN a une orientation + c sur les facettes <111> 310 du silicium, l'orientation initiale du silicium est choisie précisément de façon à sélectionner l'orientation semi-polaire voulue de la surface de la couche de GaN.

Comme représenté sur la figure 3b la méthode consiste à protéger toutes les surfaces, à l'exception des facettes 310 d'orientation (1̅1̅1) à partir desquelles la croissance va être effectuée, en procédant au dépôt d'un masque 331.

Le masque 331 est par exemple obtenu par dépôt d'une couche 331 de masquage dans une direction inclinée par rapport à la perpendiculaire à la surface supérieure du substrat 300 de manière à recouvrir les surfaces des facettes 330. L'inclinaison est telle qu'elle laisse libre d'oxyde les seules facettes 310.

La couche 331 de masquage est de préférence formée d'un diélectrique, par exemple de SiO2 ou de SiN ou de leur combinaison.

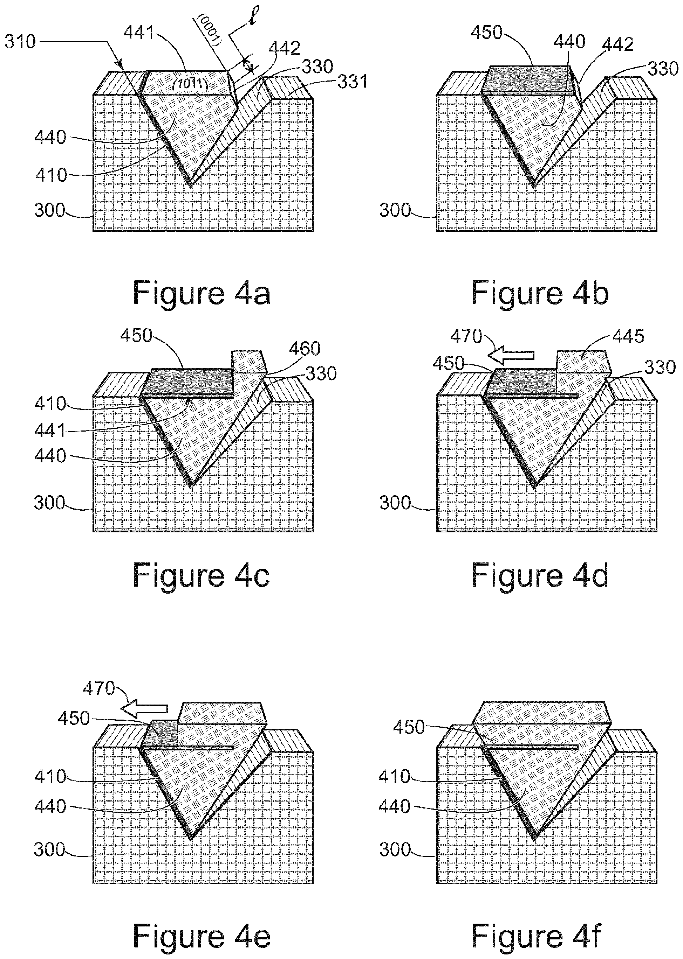

Comme montré sur la figure 3c la croissance du matériau à base de GaN se fait donc à partir des facettes 310 qui ne sont pas protégées par la couche de masquage 331, tel qu'un oxyde dans la direction notée [0001]. L'opération est poursuivie jusqu'à ce qu'une coalescence des zones adjacentes de croissance 340 du matériau à base de GaN se produise. On obtient alors, comme représenté sur la figure 4d, une couche semi-polaire continue 350 d'orientation (101̅1) dans ce cas.

D'autres méthodes similaires sont envisageables, par exemple en partant d'un substrat de silicium d'orientation (113) qui permet d'obtenir une couche continue du matériau à base de GaN d'orientation (112̅2) ou encore en partant d'un substrat de silicium d'orientation (114), avec un décalage d'orientation cristallographique de un degré d'angle par rapport à ce plan, qui permet d'obtenir une couche continue du matériau à base de GaN d'orientation (202̅1). Un processus similaire existe également qui est adapté pour l'obtention de couches semi-polaires sur des substrats de saphir structurés.

Toutefois, un problème commun à toutes ces couches hétéro-épitaxiales est que la structure cristalline de celles-ci est fortement perturbée par la présence d'un grand nombre de défauts incluant, d'une part, des défauts dits BSF, acronyme de l'anglais « basal stacking fault », c'est-à-dire des fautes d'empilement et, d'autre part, des défauts dits TD, acronyme de l'anglais « threading dislocation » c'est-à-dire des dislocations filaires qui se propagent dans toute la structure cristalline lors de la croissance du cristal.

De nombreuses méthodes ont été proposées pour prévenir et/ou corriger les différents types de défauts cristallins produits lors de la croissance du matériau à base de GaN.

La présente invention décrit une solution qui permet de former une couche semi-polaire de nitrure avec un taux de défauts moindre.

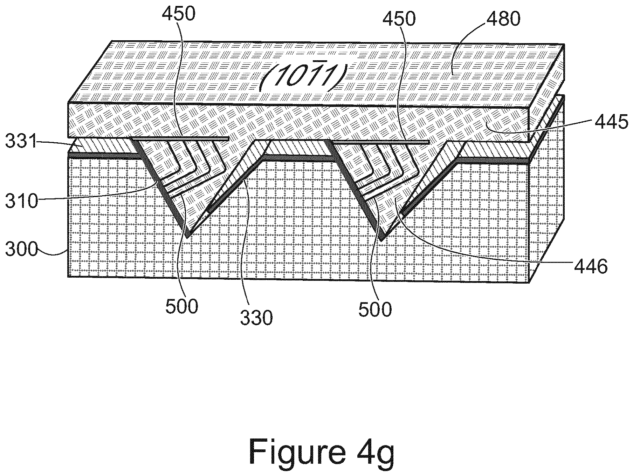

La **figure 4****,** composée des figures 4a à 4g, illustre d'autres étapes entrant dans la mise en oeuvre d'un exemple de procédé de l'invention.

Pour parvenir à l'étape illustrée en figure 4a, on effectue au préalable les étapes décrites ci-dessus en référence aux figures 3a et 3b. Ces étapes préalables 3a et 3b appartiennent donc au procédé selon la présente invention.

Dans le cas où la couche semi-polaire que l'on souhaite former est du nitrure de gallium (GaN), on forme une couche tampon 410 de nitrure d'aluminium (AIN), directement au contact des facettes 310 présentant une orientation cristalline <111>, comme cela a été mentionné dans la description de la figure 3. Cette couche tampon 410 s'est avérée être efficace notamment, pour réduire les réactions chimiques entre le gallium et le silicium entrainant une gravure par refusion habituellement appelée « meltback etching ».

En effet, la croissance de GaN sur un substrat de silicium se heurte à des difficultés liées à l'apparition d'un phénomène de « melt-back etching » lors de l'étape de croissance de la couche de nitrure telle qu'une couche de GaN. Ce phénomène destructif s'explique par la réactivité du silicium avec le Gallium. Notamment, lors de la phase de croissance des cristallites le silicium voit sa température augmenter suffisamment pour qu'il puisse réagir avec le gallium. Cette réaction entraine généralement le creusement de cavités dans le silicium.

Ces cavités détériorent les qualités du substrat et donc les performances des LEDs. Par ailleurs, ils apparaissent de manière aléatoire à la surface du silicium ce qui conduit à une faible homogénéité des LED obtenues à partir d'un même empilement de couches.

La formation d'une couche tampon de nitrure d'aluminium (AIN) sur le silicium avant de commencer la croissance de GaN permet d'éviter ou de limiter cette gravure intempestive du silicium par le gallium.

Comme indiqué dans l'exemple non limitatif ci-dessus, le substrat peut être en silicium cristallin ou monocristallin. Dans ce cas, il peut s'agir d'un substrat massif de silicium ou d'un substrat élaboré de type silicium sur isolant (SOI). Selon un mode de réalisation alternatif, le substrat cristallin est formé de Ge ou de GaAs ou encore d'un alliage des matériaux suivants : Si, Ge, GaAs. L'alliage pouvant par exemple être du SiGe. De manière générale, il s'agit d'un substrat de symétrie cubique, permettant de ce fait l'apparition de facettes présentant une orientation cristalline <111 >.

On procède ensuite à la croissance de la couche semi-polaire à base de GaN à partir des facettes 310 présentant une orientation cristalline <111 >. Si ces facettes 310 présentant une orientation cristalline <111> sont recouvertes d'une couche tampon 410 d'AIN, alors la couche semi-polaire de GaN croît à partir de cette couche tampon 410 d'AIN.

La croissance de la couche semi-polaire est interrompue avant coalescence des zones 340 et donc avant d'obtenir le résultat illustré en figure 3c et 3d.

Comme représenté sur la figure 4a la croissance du matériau à base de GaN est néanmoins poursuivie jusqu'à obtention d'un germe 440 en vue d'une reprise de croissance ultérieure.

Les paramètres permettant la croissance d'un germe 440 ou cristal comme représenté sur la figure 4a sont choisis de manière à préserver une facette inclinée 442 avec une orientation cristalline (0001). Ce cristal présente également une face supérieure 441 dont l'orientation cristalline est (1011).

Dans un exemple particulier et non limitatif de mise en oeuvre du procédé de l'invention la croissance du matériau à base de GaN est effectuée dans une chambre ou enceinte confinée à une température de 1210°C, sous une pression de 300 millibars pendant une durée de 3000 secondes, soit 50 minutes. De préférence la croissance du germe 440 est effectuée par MOCVD, acronyme de metal organic chemical vapor déposition signifiant épitaxie en phase vapeur aux organométalliques. Cette croissance est de préférence réalisée directement à partir de la couche tampon 410 d'AIN. Le rapport molaire V/III du nitrure à base de gallium est dans cet exemple de 650. Plus généralement il est compris entre 550 et 750.

Naturellement en fonction des paramètres choisis pour la croissance on obtiendra des formes de germes et des tailles de facettes possiblement différentes.

C'est en contrôlant le temps de croissance que l'on s'assure que le germe 440 ne forme pas une pyramide complète et qu'il présente bien une facette inclinée 442 dont l'orientation cristalline est (0001). Par exemple pour des rainures en V, de profondeur comprise entre 50 nm et 15 µm, une croissance du GaN pendant une durée de 3000 secondes permet d'obtenir dans chaque rainure 320 une facette inclinée 442 dont la largeur « l » est supérieure à 30 nm et de préférence comprise entre 100 et 2000 nm et de préférence de l'ordre de 200 nm. Cette largeur l, référencée en figure 4a est prise selon une direction contenue dans le plan de ladite facette inclinée 442 et perpendiculaire à la direction principale selon laquelle la rainure 320 s'étend.

De manière générale, pour déterminer le temps de croissance du germe 440 et le stopper à temps pour qu'il forme une facette inclinée 442 dont l'orientation cristalline est (0001), on prend en compte en particulier les paramètres suivants : ratio de débit de gaz, température, pression etc.

Comme illustré en figure 4b, on procède ensuite à une étape de modification d'une portion supérieure du germe 440.

Cette étape consiste en un traitement de surface du germe 440. Il permet d'obtenir une zone superficielle qui est modifiée par incorporation de silicium. Cette zone ou portion modifiée est référencée 450 sur les figures 4b et suivante.

Cette portion modifiée comprend du silicium (Si) et possiblement du nitrure de silicium (SiN). De manière plus générale cette portion modifiée 450 comprend au moins du gallium (Ga), de l'azote (N) et du silicium (Si). Selon un mode de réalisation elle contient uniquement du gallium (Ga), de l'azote (N) et du silicium (Si).

Naturellement en dehors de cette portion modifiée par cette étape de traitement, le germe 440 ne comprend pas de silicium.

A titre d'exemple non limitatif, la teneur en silicium de la portion modifiée 450 située au-dessus de la facette supérieure 441 est de 5% atomique. Plus généralement la teneur en silicium de la portion modifiée 450 située au-dessus de la facette supérieure 441 est comprise entre 3% et 10% atomique. Plus généralement la teneur en silicium de la portion modifiée 450 située au-dessus de la facette supérieure 441 est comprise entre 3% et 20% atomique. Ces teneurs permettent de modifier la portion supérieure du GaN de manière à bloquer très efficacement les dislocations au niveau de la facette supérieure 451 tout en permettant une reprise de croissance par épitaxie au niveau de la facette semi polaire 452 d'orientation (0001).

Cette portion modifiée 450 comprenant du silicium est au moins située sur la face supérieure 441 du germe 440.

De préférence ce traitement se fait in-situ, dans la même chambre que l'opération précédente, en maintenant les mêmes conditions de pression et de température. Avantageusement, la modification de cette portion 450 est de préférence réalisée par MOCVD. Ce type de traitement permet de limiter cette portion modifiée 450 à une épaisseur très faible comme cela sera précisé ci-dessous. Par ailleurs, cela permet de ne pas changer de chambre au cours des différentes étapes ce qui est avantageux en termes de simplicité et de coût de procédé.

La modification de cette portion 450, comprenant du Si dans ce cas, est par exemple effectuée en injectant dans la chambre, pendant 70 secondes dans cet exemple, d'une part : de l'ammoniac (NH3) sous forme gazeuse avec un débit de 5 slm, acronyme de l'anglais « standard liter per minute », c'est-à-dire 5 « litres par minute » et, d'autre part : du silane (SiH4) avec un débit de 100 sccm, acronyme de l'anglais « standard cubic centimer per minute », c'est-à-dire 5 centimètres cube par minute. Naturellement des valeurs bien différentes de ces paramètres peuvent être utilisées pour obtenir la modification de cette portion 450. Pour contrôler l'épaisseur de cette portion modifiée on jouera par exemple sur les paramètres suivants : température, rapport de flux des gaz, pression etc.

Selon d'autres exemples non limitatifs on pourra prendre des valeurs parmi les intervalles suivants :
- Flux de SiH4: entre 5 et 3000 sccm
- Flux de NH3: entre 0.2 et 15 slm
- Température : entre 600 et 1200 °C
- Pression: entre 20 et 800 mbar

La portion modifiée comprenant du silicium 450 est une couche très mince, dont l'épaisseur, prise sur la face supérieure 441 du germe 440 est supérieure à une épaisseur monoatomique (i.e., l'épaisseur d'une couche monoatomique ou monocouche du matériau constituant la portion modifiée 450) et de préférence supérieure à l'épaisseur de deux couches atomiques. Elle est plus généralement comprise entre une épaisseur monoatomique et seize couches atomiques c'est-à-dire, typiquement, dans une gamme d'épaisseur allant de 0,3 nanomètre (ou nm = 10⁻⁹ mètre) à 5 nm.

De manière plus générale la portion modifiée comprenant du silicium 450 est formée par injection de gaz dans la chambre pendant une durée comprise entre 10 et 100 secondes.

De manière inattendue, on constate que la modification du GaN par incorporation de silicium, se fait sélectivement sur la facette supérieure 441 de germe 440 et ne se fait pas ou pas de façon continue notamment sur la facette inclinée 442 d'orientation (0001).

Il a été observé que sur la facette inclinée 442 du germe 440, le traitement par incorporation de Si n'est pas continu et laisse des régions dans lesquelles il n'y a pas de Si.

Cette discontinuité de la modification du germe permet qu'une reprise de croissance du GaN puisse ensuite se faire à partir de cette facette 442. Typiquement l'épaisseur de la portion modifiée comprenant du silicium 450, prise sur la face inclinée 442 du germe 440 est égale ou strictement inférieure à une couche. Ainsi, la portion modifiée comprenant du silicium présente sur la facette inclinée une épaisseur inférieure ou égale 0,3 nm.

A l'inverse, le traitement conduit à une modification du GaN continue sur toute la facette supérieure 441, formant ainsi une portion 450 continue comprenant du Si sur cette facette supérieure 441.

Ensuite, dans le même équipement et pendant par exemple 10 minutes sans que cette durée soit limitative dans ce contexte, on reprend la croissance du matériau à base de GaN en utilisant les mêmes conditions que pour la croissance initiale du germe 440. Comme le montre la figure 4c, après avoir modifié la portion 450 par incorporation de silicium, la reprise de nucléation du matériau à base de GaN se produit alors uniquement à partir de la facette inclinée 442 d'orientation (0001). Le germe 440 présente alors l'extension 460 illustrée en figure 4c. On ne constate plus aucune nucléation sur la facette supérieure 441 d'orientation (1011) couverte par la portion modifiée 450 comprenant du silicium.

Cette absence de croissance du GaN à partir de la facette supérieure 441 alors que le GaN croît à partir de la facette inclinée 442 d'orientation (0001) peut reposer sur plusieurs explications. Dans le cadre du développement de la présente invention, plusieurs explications ont été envisagées pour essayer de comprendre cette différence de croissance du GaN. Il est probable que c'est la combinaison de ces explications qui est à l'origine de cette différence de croissance du GaN.

Une explication envisageable serait que la discontinuité de la modification sur la facette inclinée 442 permette une reprise de croissance du GaN par épitaxie là où la facette inclinée 442 n'est pas modifiée alors que la modification continue sur la facette supérieure 441 bloque la reprise de croissance.

Une autre explication envisageable serait qu'à l'intersection entre la facette supérieure 441 et la facette inclinée 442 il y ait plus de liaison disponibles pour y ré-initier la croissance, ceci favorisant la croissance du GaN à cette intersection.

Une autre explication envisageable serait que les différences en termes de vitesse de dépôt et en termes de densité et de structure cristalline concernant la portion modifiée 450 comprenant du silicium sur la facette supérieure 441 d'une part et sur la facette supérieure 442 d'autre part, induisent des affinités différentes avec le GaN et la possibilité ou non de poursuivre une croissance par nucléation.

Comme montré sur les figures 4d à 4g, la croissance du matériau à base de GaN se poursuit ensuite latéralement 470 jusqu'à recouvrir complètement la portion modifiée 450 comprenant du silicium comme illustré par la figure 4f.

De manière particulièrement avantageuse, la portion modifiée 450 comprenant du silicium empêche la propagation des dislocations filaires (TD) dans la portion supérieure 445 du germe 440, c'est-à-dire la portion située au-dessus de la portion modifiée 450. Il semble qu'au contact de la portion modifiée 450 comprenant du silicium ces dislocations se courbent et se propagent dans un plan parallèle à cette portion modifiée 450 mais sans la traverser. Les dislocations restent ainsi confinées dans la portion inférieure 446 du germe 440, c'est-à-dire la portion située au-dessous de la portion modifiée 450.

Au niveau de la facette inclinée 442 d'orientation (0001), les dislocations ne se propagent pas dans la portion supérieure 445 du germe 440 située au-dessus de la portion modifiée 450 comprenant du silicium.

La figure 4g illustre le résultat obtenu après poursuite de la croissance de la couche semi-polaire 480 jusqu'à coalescence des germes 440.

Sur cette figure sont représentées de manière schématique les dislocations 500 qui se propagent depuis l'interface facettes <111>/ AIN /GaN puis qui se courbent et dont la progression dans le plan est stoppée par la couche modifiée 450 comprenant du silicium.

La couche semi-polaire 480 ainsi obtenue peut ensuite être détachée de son substrat 300 pour former un dispositif microélectronique.

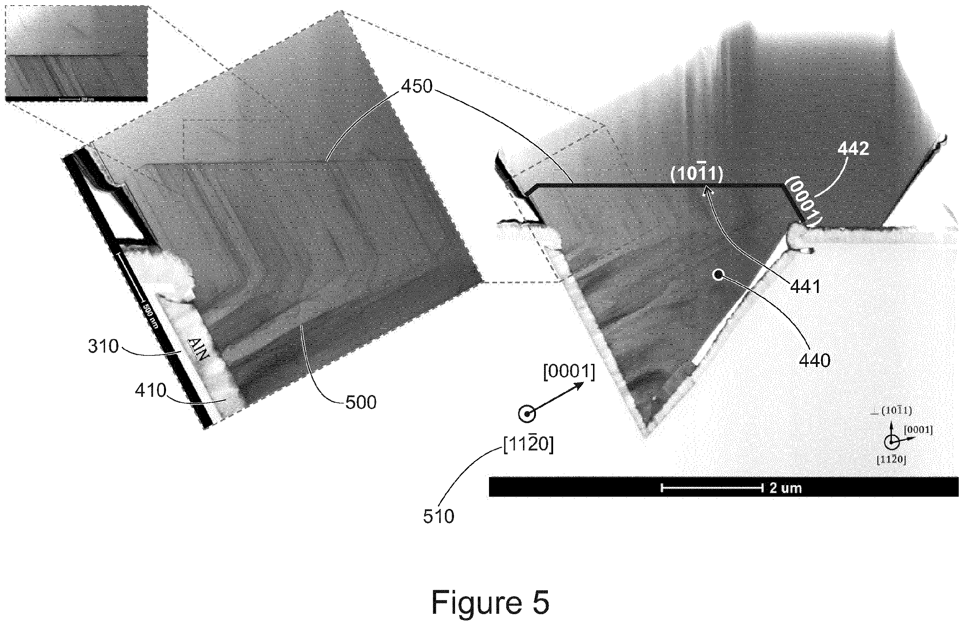

La **figure 5** montre des photos d'échantillons de cristaux de GaN qui ont été réalisés selon le procédé de l'invention décrit dans la figure précédente. Les photos ont été prises à l'aide d'un système de microscopie électronique dit STEM, acronyme de l'anglais « scanning transmission electron microscopy » c'est-à-dire « microscope électronique à balayage par transmission ». La figure 5 montre des images en coupe de la zone d'un cristal dont la croissance a été obtenue comme décrit précédemment, c'est-à-dire à partir de la facette 442 d'un germe 440 pyramidal. Les photos ont été acquises avec différents grossissements dans l'axe de zone [112̅0] 510. On y voit que les dislocations filaires (TD) 500 sont complètement bloquées dans le plan où la portion modifiée comprenant du silicium 450 est présente.

Sur les observations réalisées sur les germes après modification par incorporation de Si, on ne voit pas apparaître une couche de cristallinité différente à l'interface où a été réalisé le traitement par incorporation de Si dans le GaN. Seule une variation de contraste chimique est vue à cette interface. La durée du traitement, la température, la pression du réacteur et les flux de gaz utilisés pour ce traitement sont les paramètres d'ajustement qui pilotent l'épaisseur de cette zone interfaciale.

De nombreuses variantes peuvent être apportées au mode de réalisation non limitatif décrit en référence aux figures 3a et 3b et 4a à 4g.

Par exemple, les rainures 320 ne sont pas nécessairement en V. Elles peuvent présenter un fond plat. Les facettes 310 présentant une orientation cristallographique <111> peuvent ainsi s'arrêter sur un fond de rainure sans rejoindre directement les facettes opposées 311.

L'invention n'est pas limitée aux modes de réalisation décrits ci-dessus et s'étend à tous les modes de réalisation couverts par les revendications.

## Revendications

1. Procédé permettant d'obtenir au moins une couche semi-polaire (480) de nitrure obtenue à partir d'un matériau à base de gallium (Ga) et d'azote (N) sur une surface supérieure d'un substrat cristallin (300) de symétrie cubique, le procédé comprenant au moins les étapes suivantes:
- graver une pluralité de rainures parallèles (320) à partir de la surface supérieure du substrat cristallin (300), chaque rainure (320) comprenant au moins deux facettes inclinées opposées (310, 311), au moins l'une (310) desdites deux facettes opposées (310, 311) présentant une orientation cristalline <111> ;
- former un masque (331) au-dessus de la surface supérieure du substrat cristallin (300) de telle sorte que les facettes (311) opposées auxdites facettes (310) présentant une orientation cristalline <111> soient masquées et que lesdites facettes (310) présentant une orientation cristalline <111> ne soient pas masquées ;
- après ladite étape de formation du masque (331), former ladite couche semi-polaire (350) de nitrure par croissance épitaxiale à partir desdites facettes (310) non masquées présentant une orientation cristalline <111>;
**caractérisé en ce que** ladite étape de formation de ladite couche semi-polaire (350) comprend au moins les étapes suivantes
- au moins une première phase de croissance épitaxiale, réalisée à partir desdites facettes (310) non masquées présentant une orientation cristalline <111> de manière à former un germe (440) dans une pluralité au moins de rainures parallèles (320);
- interruption de la première phase de croissance épitaxiale lorsque ledit germe (440) présente une facette inclinée (442) présentant une orientation cristalline (0001) et une facette supérieure (441) présentant une orientation semi-polaire cristalline (1011);
- une étape de traitement de surface comprenant une modification d'une portion supérieure du germe (440) par mise en présence du germe (440) avec au moins un gaz comprenant du silicium (Si) de manière à former à la surface du germe (440) une portion modifiée (450) comprenant du silicium (Si);
- au moins une deuxième phase de croissance épitaxiale dudit matériau, réalisée à partir de ladite facette inclinée (442) présentant une orientation cristalline (0001), la deuxième phase de croissance épitaxiale étant poursuivie jusqu'à coalescence de germes (440) de rainures parallèles (320) adjacentes.

2. Procédé selon la revendication précédente, dans lequel au cours de la deuxième phase de croissance épitaxiale ladite couche semi-polaire (480) de nitrure (N) recouvre une partie au moins de la portion modifiée (450) comprenant du silicium.

3. Procédé selon l'une quelconque des revendications précédentes, dans lequel la portion modifiée (450) comprenant du silicium est continue sur ladite facette supérieure (441) du germe (440).

4. Procédé selon l'une quelconque des revendications précédentes, dans lequel la portion modifiée (450) comprenant du silicium est absente ou discontinue sur la facette inclinée (442) présentant une orientation cristalline (0001).

5. Procédé selon l'une quelconque des revendications précédentes, dans lequel la teneur en silicium de la portion modifiée située au-dessus de la facette supérieure (441) présentant une orientation semi-polaire cristalline (1011) est comprise entre 3% et 20% en pourcentage atomique.

6. Procédé selon l'une quelconque des revendications précédentes, dans lequel ladite modification d'une portion supérieure du germe (440) comprend une exposition du germe (440) à un flux combiné de gaz comprenant du SiH4 et du NH3.

7. Procédé selon la revendication précédente, dans lequel l'épaisseur de la portion modifiée (450) comprenant du silicium est contrôlée en régulant au moins le rapport des débits de SiH4 et de NH3 et/ou en régulant la durée d'exposition.

8. Procédé selon l'une quelconque des revendications précédentes, dans lequel l'épaisseur de la portion modifiée (450) comprenant du silicium est contrôlée en régulant au moins l'un des paramètres suivants : débit, température et pression d'injection de l'au moins un gaz comprenant du silicium.

9. Procédé selon l'une quelconque des revendications précédentes, dans lequel la portion modifiée (450) comprenant du silicium surmontant la facette supérieure (441) a une épaisseur strictement supérieure à une couche monoatomique et de préférence supérieure ou égale à seize couches monoatomiques.

10. Procédé selon l'une quelconque des revendications précédentes, dans lequel la portion modifiée (450) comprenant du silicium surmontant la facette supérieure (441) a une épaisseur strictement supérieure à 0,3 nm et de préférence supérieure à 5 nm

11. Procédé selon l'une quelconque des revendications précédentes, dans lequel la portion modifiée (450) comprenant du silicium surmontant la facette inclinée (442) a une épaisseur égale ou inférieure à 0.3 nm.

12. Procédé selon l'une quelconque des revendications précédentes, dans lequel la portion modifiée (450) comprenant du silicium surmontant la facette inclinée (442) a une épaisseur égale ou inférieure à une seule couche monoatomique.

13. Procédé selon l'une quelconque des revendications précédentes, dans lequel au moins la première phase de croissance épitaxiale et la modification d'une portion supérieure du germe (440) sont effectuées dans le même réacteur.

14. Procédé selon l'une quelconque des revendications précédentes, dans lequel la modification d'une portion supérieure du germe (440) est effectuée par épitaxie en phase vapeur aux organométalliques (MOCVD).

15. Procédé selon l'une quelconque des revendications précédentes, dans lequel ladite étape d'interruption est déclenchée au bout d'une durée prédéterminée.

16. Procédé selon l'une quelconque des revendications précédentes, dans lequel la première phase de croissance épitaxiale dudit matériau à partir de la facette (310) présentant une orientation cristalline <111> est interrompue avant que le germe (440) ne remplisse ladite rainure.

17. Procédé selon l'une quelconque des revendications précédentes, dans lequel avant l'étape de croissance épitaxiale dudit matériau à partir des facettes (310) présentant une orientation cristalline <111>, on forme une couche tampon (410) d'AIN sur les facettes (310) présentant une orientation cristalline <111>.

18. Procédé selon l'une quelconque des revendications précédentes, dans lequel le substrat cristallin (300) est formé de l'un des matériaux suivants, ou est à base de l'un des matériaux suivants ou est formé d'un alliage des matériaux suivants : Si, Ge, GaAs.

## Patentansprüche

1. Verfahren zum Erhalten mindestens einer halbpolaren Schicht (480) aus Nitrid, das aus einem Material auf der Basis von Gallium (Ga) und Stickstoff (N) erhalten wird, auf einer oberen Oberfläche eines kubisch symmetrischen kristallinen Substrats (300), wobei das Verfahren mindestens die folgenden Schritte umfasst:
das Ätzen einer Vielzahl von parallelen Rillen (320) von der oberen Oberfläche des kristallinen Substrats (300), wobei jede Rille (320) mindestens zwei gegenüberliegende geneigte Facetten (310, 311) umfasst, wobei mindestens eine (310) der zwei gegenüberliegenden Facetten (310, 311) eine <111 > Kristallorientierung aufweist;
das Bilden einer Maske (331) über der oberen Oberfläche des kristallinen Substrats (300), so dass die Facetten (311), die den Facetten (310) mit einer <111>-Kristallorientierung gegenüberliegen, maskiert werden und die Facetten (310) mit einer <111 >-Kristallorientierung nicht maskiert werden;
nach dem Schritt des Bildens der Maske (331) das Bilden der halbpolaren Schicht (350) aus Nitrid durch epitaktisches Wachstum aus den unmaskierten Facetten (310), die eine <111 > Kristallorientierung aufweisen;
**dadurch gekennzeichnet, dass** der Schritt des Bildens der halbpolaren Schicht (350) mindestens die folgenden Schritte umfasst
- mindestens eine erste epitaktische Wachstumsphase, die ausgehend von den unmaskierten Facetten (310) mit einer Kristallorientierung <111 > durchgeführt wird, um einen Keim (440) in einer Vielzahl von mindestens parallelen Rillen (320) zu bilden;
- das Unterbrechen der ersten epitaktischen Wachstumsphase, wenn der Keim (440) eine schräge Facette (442) mit einer (0001)-Kristallorientierung und eine obere Facette (441) mit einer halbpolaren (101̅1)-Kristallorientierung aufweist;
- einen Oberflächenbehandlungsschritt, der eine Modifizierung eines oberen Abschnitts des Keims (440) umfasst, indem der Keim (440) mit mindestens einem Gas, das Silizium (Si) umfasst, in Berührung gebracht wird, um auf der Oberfläche des Keims (440) einen modifizierten Abschnitt (450) zu bilden, der Silizium (Si) umfasst;
- mindestens eine zweite epitaktische Wachstumsphase des Materials, die ausgehend von der geneigten Facette (442) mit einer (0001)-Kristallorientierung durchgeführt wird, wobei die zweite epitaktische Wachstumsphase bis zur Koaleszenz von Keimen (440) benachbarter paralleler Rillen (320) fortgesetzt wird.

2. Verfahren nach dem vorhergehenden Anspruch, wobei während der zweiten epitaktischen Wachstumsphase die halbpolare Schicht (480) aus Nitrid (N) mindestens einen Teil des modifizierten Abschnitts (450), der Silizium enthält, bedeckt.

3. Verfahren nach einem der vorhergehenden Ansprüche, wobei der modifizierte Anteil (450), der Silizium enthält, auf der oberen Facette (441) des Keims (440) kontinuierlich ist.

4. Verfahren nach einem der vorhergehenden Ansprüche, wobei der modifizierte Anteil (450), der Silizium enthält, auf der geneigten Facette (442) mit einer (0001)-Kristallorientierung nicht vorhanden oder diskontinuierlich ist.

5. Verfahren nach einem der vorhergehenden Ansprüche, wobei der Siliziumgehalt des modifizierten Abschnitts oberhalb der oberen Facette (441) mit einer halbpolaren Kristallorientierung (101̅1) zwischen 3 und 20 Atomprozent liegt.

6. Verfahren nach einem der vorhergehenden Ansprüche, wobei die Modifikation eines oberen Abschnitts des Keims (440) umfasst, dass der Keim (440) einem kombinierten Strom von Gasen ausgesetzt wird, der SiH4 und NH3 umfasst.

7. Verfahren nach dem vorhergehenden Anspruch, bei dem die Dicke des modifizierten Teils (450), der Silizium enthält, durch Regulierung zumindest des Verhältnisses der SiH4- und NH3-Flussraten und/oder durch Regulierung der Expositionszeit gesteuert wird.

8. Verfahren nach einem der vorhergehenden Ansprüche, bei dem die Dicke des Silizium enthaltenden modifizierten Abschnitts (450) durch Regulierung mindestens eines der folgenden Parameter gesteuert wird: Durchflussrate, Temperatur und Injektionsdruck des mindestens einen Silizium enthaltenden Gases.

9. Verfahren nach einem der vorhergehenden Ansprüche, wobei der modifizierte Abschnitt (450) mit Silizium über der oberen Facette (441) eine Dicke aufweist, die strikt größer als eine monoatomare Schicht und vorzugsweise größer oder gleich sechzehn monoatomaren Schichten ist.

10. Verfahren nach einem der vorhergehenden Ansprüche, wobei der modifizierte Abschnitt (450) mit Silizium über der oberen Facette (441) eine Dicke von strikt mehr als 0,3 nm und vorzugsweise mehr als 5 nm hat

11. Verfahren nach einem der vorhergehenden Ansprüche, wobei der modifizierte Abschnitt (450) mit Silizium über der geneigten Facette (442) eine Dicke von 0,3 nm oder weniger aufweist.

12. Verfahren nach einem der vorhergehenden Ansprüche, wobei der modifizierte Abschnitt (450) mit Silizium über der geneigten Facette (442) eine Dicke hat, die gleich oder kleiner als eine einzelne monoatomare Schicht ist.

13. Verfahren nach einem der vorhergehenden Ansprüche, wobei zumindest die erste epitaktische Wachstumsphase und die Modifizierung eines oberen Abschnitts des Keims (440) in demselben Reaktor durchgeführt werden.

14. Verfahren nach einem der vorhergehenden Ansprüche, wobei die Modifizierung eines oberen Abschnitts des Keims (440) durch metallorganische Dampfphasenepitaxie (MOCVD) durchgeführt wird.

15. Verfahren nach einem der vorhergehenden Ansprüche, wobei der Unterbrechungsschritt nach einer vorbestimmten Zeit ausgelöst wird.

16. Verfahren nach einem der vorhergehenden Ansprüche, bei dem die erste Phase des epitaktischen Wachstums des Materials aus der Facette (310) mit einer <111 >-Kristallorientierung unterbrochen wird, bevor der Keim (440) die Rille füllt.

17. Verfahren nach einem der vorhergehenden Ansprüche, bei dem vor dem Schritt des epitaktischen Wachstums des Materials aus ausgehend von den Facetten (310) mit einer <111>-Kristallorientierung eine Pufferschicht (410) aus AIN auf den Facetten (310) mit einer <111>-Kristallorientierung gebildet wird.

18. Verfahren nach einem der vorhergehenden Ansprüche, wobei das kristalline Substrat (300) aus einem der folgenden Materialien gebildet ist oder auf einem der folgenden Materialien basiert oder aus einer Legierung der folgenden Materialien gebildet ist: Si, Ge, GaAs.

## Claims

1. A method for obtaining at least one semi-polar nitride layer (480) obtained from a gallium and nitrogen based material on an upper surface of a crystalline substrate (300) of cubic symmetry, the method comprising:
- etching a plurality of parallel grooves (320) from the upper surface of the crystalline substrate (300), each groove (320) comprising at least two opposed inclined facets (310, 311), at least one (310) of the two opposed facets (310, 311) having a crystalline orientation <111>;
- forming a mask (331) above the upper surface of the crystalline substrate (300) such that the facets (311) opposite to the facets (310) having the crystalline orientation <111> are masked and that said facets (310) having the crystalline orientation <111> are not masked; and
- after the step of forming the mask (331), forming the semi-polar nitride layer (350) by epitaxial growth from the non-masked facets (310) having the crystalline orientation <111>;
**characterized in that** the step of forming the semi-polar nitride layer (350) comprises at least the following steps:
- at least one first epitaxial growth phase, carried out from the non-masked facets (310) having the crystalline orientation <111> so as to form a seed (440) in a plurality at least of parallel grooves (320);
- interrupting the first epitaxial growth phase when the seed (440) has an inclined facet (442) having a crystalline orientation (0001) and an upper facet (441) having a crystalline semi-polar orientation (1011);
- a step of surface treatment comprising a modification of an upper portion of the seed (440) by placing the seed (440) in presence with at least one gas comprising silicon (Si) so as to form on the surface of the seed (440) a modified portion (450) comprising silicon (Si); and
- at least one second epitaxial growth phase of the material, carried out from the inclined facet (442) having a crystalline orientation (0001), the second epitaxial growth phase being continued until coalescence of seeds (440) of adjacent parallel grooves (320).

2. The method according to the preceding claim, wherein during the second epitaxial growth phase the semi-polar layer (480) of nitride (N) covers one part at least of the modified portion (450) comprising silicon.

3. The method according to any of the preceding claims, wherein the modified portion (450) comprising silicon is continuous on the upper facet (441) of the seed (440).

4. The method according to any of the preceding claims, wherein the modified portion (450) comprising silicon is absent or discontinuous on the inclined facet (442) having the crystalline orientation (0001).

5. The method according to any of the preceding claims, wherein the silicon content of the modified portion located above the upper facet (441) having a crystalline semi-polar orientation (101̅1) is between 3% and 20% in atomic percentage.

6. The method according to any of the preceding claims, wherein the modification of an upper portion of the seed (440) comprises an exposure of the seed (440) to a combined flow of gas comprising SiH4 and NH3.

7. The method according to the preceding claim, wherein the thickness of the modified portion (450) comprising silicon is controlled by regulating at least the ratio of flow rates of SiH4 and NH3 and/or by regulating an exposure time.

8. The method according to any of the preceding claims, wherein the thickness of the modified portion (450) comprising silicon is controlled by regulating at least one of the following parameters: flow rate, temperature and injection pressure of the at least one gas comprising silicon.

9. The method according to any of the preceding claims, wherein the modified portion (450) comprising silicon sitting on top of the upper facet (441) has a thickness strictly greater than one monoatomic layer and, preferably, greater than or equal to sixteen monoatomic layers.

10. The method according to any of the preceding claims, wherein the modified portion (450) comprising silicon sitting on top of the upper facet (441) has a thickness strictly greater than 0.3 nm and, preferably, greater than 5 nm.

11. The method according to any of the preceding claims, wherein the modified portion (450) comprising silicon sitting on top of the inclined facet (442) has a thickness less than or equal to 0.3 nm.

12. The method according to any of the preceding claims, wherein the modified portion (450) comprising silicon sitting on top of the inclined facet (442) has a thickness less than or equal to one single monoatomic layer.

13. The method according to any of the preceding claims, wherein at least the first epitaxial growth phase and the modification of an upper portion of the seed (440) are performed in the same reactor.

14. The method according to any of the preceding claims, wherein the modification of an upper portion of the seed (440) is performed by metalorganic vapor epitaxy (MOCVD).

15. The method according to any of the preceding claims, wherein the interruption is triggered after a predetermined period.

16. The method according to any of the preceding claims, wherein the first epitaxial growth phase of the material from the facet (310) having a crystalline orientation <111> is interrupted before the seed (440) fills the groove.

17. The method according to any of the preceding claims, wherein before the epitaxial growth step of the material from the facets (310) having a crystalline orientation <111>, a buffer layer (410) of AIN is formed on the facets (310) having a crystalline orientation <111>.

18. The method according to any of the preceding claims, wherein the crystalline substrate (300) is formed of at least one of the following materials or is based on one of the following materials, or is formed of an alloy of the following materials: Si, Ge, and GaAs.
